# EUROPEAN PATENT APPLICATION

(11) **EP 2 490 221 A1**
(43) Date of publication of application: **22.08.2012**
(21) Application number: 11154812.9
(22) Date of filing: 17.02.2011
(51) Int. Cl.: G11C 11/405, G11C 7/02, G11C 11/4097, G11C 7/18

(54) **Memory cell and memory array utilizing the memory cell**

(71) Applicant: Nanya Technology Corporation, Kueishan, Taoyuan (TW)
(72) Inventor: Ting, Tah-Kang Joseph, 308, Hsinchu County (TW)
(74) Representative: Becker Kurig Straus

(57) **Abstract**

This invention relates to a memory cell (100) having a first switch device (105), a second switch device (107) and a capacitor (109). The first switch device (105) has: a control terminal for receiving a first control signal (CS₁) transmitted by a first select line (102), wherein the first switch device is turned on or turned off according to the first control signal (CS₁); a first terminal, coupled to a data line (101); and a second terminal. The second switch device (107) has: a first terminal, coupled to the second terminal of the first switch device (105); a control terminal for receiving a second control signal (CS2) transmitted by a second select line (103), wherein the second switch device (107) is turned on or turned off according to the second control signal (CS2); and a second terminal. The capacitor (109) has a first terminal coupled to the second terminal of the second switch device (107) and a second terminal coupled to a predetermined voltage level. The data is read from the capacitor (109) or written to the capacitor (109) via the data line (101).

## Description

The present invention relates to a memory cell and a memory array utilizing the memory cell according to the pre-characterizing clauses of claims 1 and 6 respectively.

A conventional DRAM cell includes a bit line (also called a data line), a word line (also called a select line), a switch device (always be a transistor), and a capacitor. The capacitor is utilized to store data (logic value 0 or 1). The switch device is turned on or turned off according to a signal transmitted by the word line. The bit line is utilized to transmit the data read from the capacitor, or the data written to the capacitor, when the switch device is turned on.

Recently, there has been a tendency to minimize the size of electronic apparatuses. Accordingly, the sizes of DRAM cells are also becoming smaller, thus significantly decreasing the distances between bit lines. In such structure, adjacent bit lines may suffer unwanted coupling effect to generate noise to each other, and the data transmitted by bit lines may therefore be wrongly determined. For example, data 0 maybe wrongly determined to be 1, and data 1 maybe wrongly determined to be 0.

This in mind, the present invention aims at providing a memory cell and a memory array utilizing the memory cell.

This is achieved by a memory cell and a memory array utilizing the memory cell according to claims 1 and 6, respectively. The dependent claims pertain to corresponding further development and improvements.

As will be seen more clearly from the detailed description below, the memory cell includes a first switch device, a second switch device, and a capacitor. The first switch device has: a control terminal for receiving a first control signal transmitted by a first select line, wherein the first switch device is turned on or turned off according to the first control signal; a first terminal, coupled to a data line; and a second terminal. The second switch device has: a first terminal, coupled to the second terminal of the first switch device; and a control terminal for receiving a second control signal transmitted by a second select line, wherein the second switch device is turned on or turned off according to the second control signal; and a second terminal. The capacitor has a first terminal coupled to the second terminal of the second switch device and a second terminal coupled to a predetermined voltage level. The data is read from the capacitor or written to the capacitor via the data line.

Additionally, the memory array includes a plurality of the memory cells, wherein the memory cells in the memory array can be classified into multiple groups of memory cells, and the data lines of the memory array are arranged in a way that no adjacent data lines are from the same group of memory cells. In this arrangement, the memory operation can be designed such that when the data lines of one of the multiple groups of memory cells are transmitting data, the data lines of the other groups of memory cells are not transmitting data. In this way, the noise coupling effect between data lines is minimized,

In the following, the invention is further illustrated by way of example, taking reference to the accompanying drawings. Thereof
FIG.1 is a circuit diagram illustrating a memory cell according to one embodiment of the present application, and
FIG.2 is a circuit diagram illustrating a memory array according to one embodiment of the present application.

Certain terms are used throughout the description and following claims to refer to particular components. As one skilled in the art will appreciate, electronic equipment manufacturers may refer to a component by different names. This document does not intend to distinguish between components that differ in name but not function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections. Please note that a DRAM is utilized for explaining the following embodiments. The following embodiments can be applied to other memories, however.

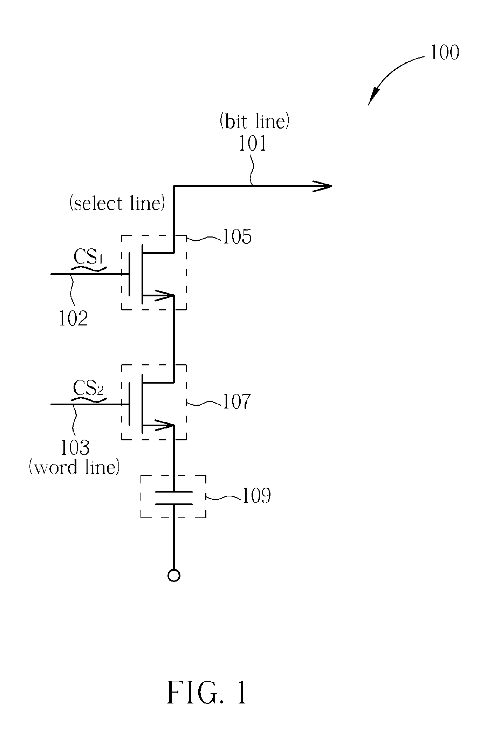

Please refer to FIG.1, which is a circuit diagram illustrating a memory cell 100 according to one embodiment of the present application. As shown in FIG.1 the memory cell 100 includes a first switch device 105, a second switch device 107 and a capacitor 109. The first switch device 105 includes a control terminal for receiving a first control signal CS₁. The first switch device 105 is turned on or turned off according to the first control signal CS₁. A first terminal of the first switch device 105 is coupled to a data line 101.

The second switch device 107 includes a control terminal for receiving a second control signal CS₂ transmitted by a select line 103 , and is turned on or turned off according to the second control signal CS₂. A first terminal of the second switch device 107 is coupled to a second terminal of the first switch device 105 (in this embodiment, they are directly connected). The capacitor 109 is utilized for storing data, and the data is read from the capacitor 109 or written to the capacitor 109 via the data line 101 when both the first switch device 105 and the second switch device 107 are turned on. The capacitor 109 includes a first terminal coupled to a second terminal of the second switch device 107, and a second terminal coupled to a predetermined voltage level. In a conventional memory cell having only the second switch device 107 and the capacitor 109, when the second switch device 107 is turned on, the data line 101 is electronically connected to the capacitor 109 and can transmit data to the capacitor 109 or read data from the capacitor 109. If, however, the memory cell further includes the first switch device 105, the data line 101 will transmit no data and remain silent when the first switch device 105 is turned off, even if the second switch device 107 is turned on. In this case, the first control signal CS₁ can be transmitted via a select line 102 , which is coupled to a control terminal of the first switch device 105.

If the memory cell 100 is a DRAM cell, the data line 101 is a bit line, and the select line 103 is a word line. Also, transistors such as NMOSFETs can be implemented as switch devices 105 and 107. In this case, first terminals of the first and the second switch devices 105 and 107 are drain terminals, control terminals of the first and the second switch devices 105 and 107 are gate terminals, and the second terminals of the first and the second switch devices 105 and 107 are source terminals. Please note that this example is not intended to limit the scope of the present application. For example, other devices that can be utilized as switch devices, such as PMOSFETs or BJTs, can also be the switch devices 105 and 107. Also the select line 102, instead of 103, can be used as the word line.

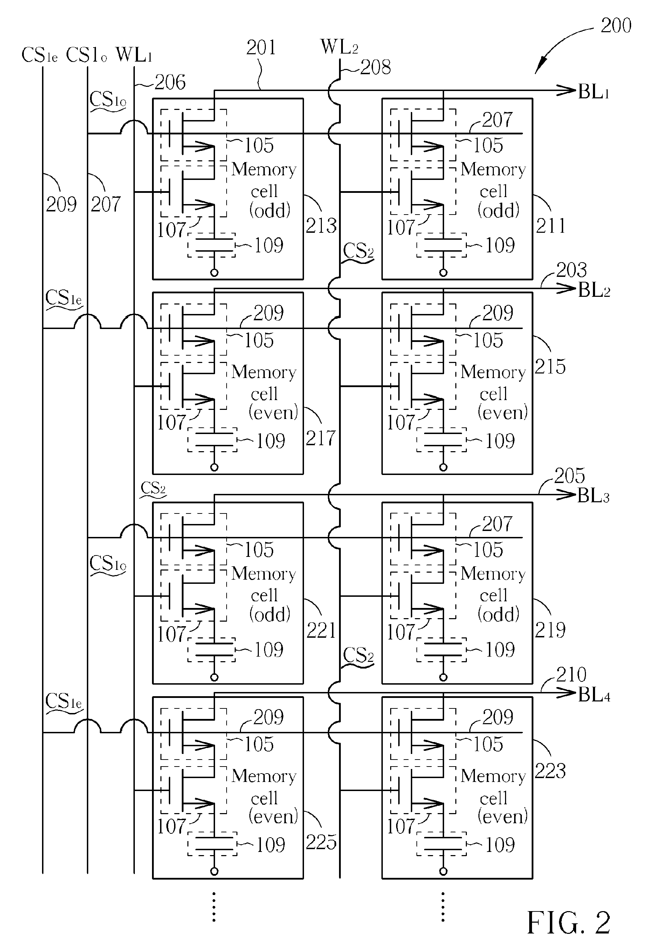

Please refer to FIG.2, which illustrates a memory array 200 utilizing memory cells illustrated in FIG.1, according to one embodiment of the present application. As shown in FIG.2, the memory 200 includes a plurality of memory cells 211-225. Each of the memory cells 211-225 includes a first switch device 105, a second switch device 107 and a capacitor 109, as in the memory cell shown in FIG.1. In one embodiment, the memory cells 211-225 can be classified into odd memory cells (211, 213, 219, 221) and even memory cells (215, 217, 223, 225). The column select lines 207, 209 (i.e. the select line 102 in FIG.1) respectively serve to transmit control signals CS1ₒ and CS1ₑ. The column select lines 207, 209 are respectively coupled to odd memory cells and even memory cells to control the first switch devices 105 thereof. The odd memory cells 211, 213, 219, 221 are controlled by the column select line 207 and the select lines 206, 208 (WL₁, WL₂). Also, the even memory cells 215, 217, 223 and 225 are controlled by the column select line 209, and the select lines 206, 208.

In one embodiment, when the data lines 201, 205 (BL1, BL3) of the odd memory cells 211, 213, 219, 221 are transmitting data, the first switch devices 105 in the even memory cells 215, 217, 223, 225 are controlled by the control signal CS1ₑ to be turned off, such that the data lines 203 and 210 (BL2, BL4) of the even memory cells 215, 217, 223, 225 stop transmitting data and keep silent. Similarly, when the data lines 203 and 210 (BL2, BL4) of the even memory cells 215, 217, 223, 225 are transmitting data (ex. in a sensing stage), the first switch devices 105 in the odd memory cells 211, 213, 219 and 221 are controlled by the control signal CS₁ₒ to be turned off, such that the data lines 201. 205 (BL1, BL3) stop transmitting data and keep silent.

In this way, the data line that stops transmitting data can be utilized as shielding for the data line that transmits data, thus the two or more data lines transmitting data can be prevented from disturbing each other since there is a shielding located between two adjacent active data lines.

In view of the above mentioned embodiment shown in FIG.2, the memory array according to the present invention can be summarized as follows:
the memory cells in the memory array can be classified into a first group of memory cells and a second group of memory cells, and the data lines of the memory array are arranged in a way that no adjacent data lines are from the same group of memory cells. In this arrangement, the memory operation can be designed such that when the data lines of one of the two groups of memory cells are transmitting data, the data lines of the other group of memory cells are not transmitting data. In this way, the noise coupling effect between data lines is minimized,

It should be noted that the structure shown in FIG.2 does not mean to limit the scope of the present application. For example, the memory cells in the memory array can be classified into more than two groups. Furthermore, the operation of the memory array is not limited to be the same as above-mentioned operation.

All combinations and sub-combinations of the above-described features also belong to the invention.

## Claims

1. A memory cell (100), **characterized by**
a first switch device (105), having
a control terminal for receiving a first control signal (CS₁) transmitted by a first select line (102), wherein the first switch device (105) is turned on or turned off according to the first control signal (CS₁);
a first terminal, coupled to a data line (101); and
a second terminal;
a second switch device (107), having
a first terminal, coupled to the second terminal of the first switch device (105);
a control terminal for receiving a second control signal (CS₂) transmitted by a second select line (103), wherein the second switch device (107) is turned on or turned off according to the second control signal (CS₂); and
a second terminal; and
a capacitor (109), having a first terminal coupled to the second terminal of the second switch device (107) and a second terminal coupled to a predetermined voltage level, wherein the data is read from the capacitor (109) or written to the capacitor (109) via the data line (101).

2. The memory cell (100) of claim 1, **characterized in that** the second terminal of the first switch device (105) is directly connected to the first terminal of the second switch device (107).

3. The memory cell (100) of claim 1, **characterized in that** the memory cell is a DRAM cell, and **characterized in that** the data line (101) is a bit line, and the second select line (103) is a word line.

4. The memory cell (100) of claim 1, **characterized in that** the memory cell is a DRAM cell, and **characterized in that** the data line (101) is a bit line, and the first select line (102) is a word line.

5. The memory cell (100) of claim 1, **characterized in that** the first switch device (105) and the second switch device (107) are NMOSFETs, and **characterized in that** the first terminals of the first switch device (105) and the second switch device (107) are drain terminals, the control terminals of the first switch device (105) and the second switch device (107) are gate terminals, and the second terminals of the first switch device (105) and the second switch device (107) are source terminals.

6. The memory cell (100) of claim 1, **characterized in that** the first switch device (105) and the second switch device (107) are PMOSFETs, and **characterized in that** the first terminals of the first switch device (105) and the second switch device (107) are drain terminals, the control terminals of the first switch device (105) and the second switch device (107) are gate terminals, and the second terminals of the first switch device (105) and the second switch device (107) are source terminals.

7. A memory array (200), **characterized by**:
a plurality of memory cells (211-225), **characterized in that** each of the memory cells comprises:
a first switch device (105), having
a control terminal for receiving a first control signal (CS₁) transmitted by a first select line (207, 209), wherein the first switch device (105) is turned on or turned off according to the first control signal (CS₁);
a first terminal, coupled to a data line (201, 203, 205, 210); and
a second terminal;
a second switch device (107), having:
a first terminal, coupled to the second terminal of the first switch device (105);
a control terminal for receiving a second control signal (CS₂)transmitted by a second select line (206, 208), wherein the second switch device (107) is turned on or turned off according to the second control signal (CS₂); and
a second terminal; and
a capacitor (109), for storing data, having a first terminal coupled to the second terminal of the second switch device and a second terminal coupled to a predetermined voltage level, wherein the data is read from the capacitor or written to the capacitor via the data line (201, 203, 205, 210)

8. The memory array (200) of claim 7, **characterized in that** the memory cells in the memory array can be classified into multiple groups of memory cells, and the data lines of the memory array are arranged in a way that no adjacent data lines are from the same group of memory cells and **characterized in that** when the data lines of one of the multiple groups of memory cells are transmitting data, the data lines of the other groups of memory cells are not transmitting data.

9. The memory array (200) of claim 7, **characterized in that** the second terminal of the first switch device (105) is directly connected to the first terminal of the second switch device (107).

10. The memory array (200) of claim 7, **characterized in that** the memory array is a DRAM array, and **characterized in that** the data line (201, 203, 205, 210) is a bit line, and the second select line is a word line (206, 208).

11. The memory array (200) of claim 7, **characterized in that** the memory array is a DRAM array, and **characterized in that** the data line (201, 203, 205, 210) is a bit line, and the first select line is a word line.

12. The memory array (200) of claim 7, **characterized in that** the first switch device (105) and the second switch device (107) are NMOSFETs, and **characterized in that** the first terminals of the first switch device (105) and the second switch device (107) are drain terminals, the control terminals of the first switch device (105) and the second switch (107) are gate terminals, and the second terminals of the first switch device (105) and the second switch device (107) are source terminals.

13. The memory array (200) of claim 7, **characterized in that** the first switch device (105) and the second switch device (107) are PMOSFETs, and **characterized in that** the first terminals of the first switch device (105) and the second switch device (107) are drain terminals, the control terminals of the first switch device (105) and the second switch (107) are gate terminals, and the second terminals of the first switch device (105) and the second switch device (107) are source terminals.
